Europäisches Patentamt

European Patent Office

Office européen des brevets

(19)

(11)  **EP 0 700 151 A1**

(12)  **DEMANDE DE BREVET EUROPEEN**

(43) Date de publication:
06.03.1996  Bulletin 1996/10

(51) Int. Cl.$^6$: **H03F 3/30**, H03F 1/32

(21) Numéro de dépôt: 95202183.0

(22) Date de dépôt: 10.08.1995

(84) Etats contractants désignés:
**DE FR GB IT**

(30) Priorité: **25.08.1994 FR 9410277**

(71) Demandeurs:
- **PHILIPS COMPOSANTS**
  **F-92150 Suresnes (FR)**
  Etats contractants désignés:
  **FR**

- **PHILIPS ELECTRONICS N.V.**
  **NL-5621 BA  Eindhoven (NL)**
  Etats contractants désignés:
  **DE GB IT**

(72) Inventeur: **Gloaguen, Gilbert**
  **F-75008 Paris (FR)**

(74) Mandataire: **Pinchon, Pierre**
  **Société Civile S.P.I.D.**
  **156, Boulevard Haussmann**
  **F-75008 Paris (FR)**

(54)  **Etage amplificateur de puissance, de type suiveur**

(57)  Etage amplificateur comportant en sortie, deux transistors MOS de puissance (M1, M2) en série entre une ligne d'alimentation positive (2) et la masse (1), la grille de chacun d'eux étant commandée par des amplificateurs respectifs (A1, A2). A l'entrée de ces amplificateurs, un signal d'entrée (Vi) est appliqué pour être comparé au signal de sortie (Vo) de l'étage amplificateur.

Selon l'invention, les amplificateurs (A1, A2) sont munis chacun d'une entrée dite de blocage (20, 22) permettant de commander à la masse la grille du transistor de puissance correspondant (M2, M1) et l'étage amplificateur comporte deux transistors faisant office d'interrupteurs (SW1, SW2) réalisant la mise à la masse soit de l'une soit de l'autre des entrées de blocage (20, 22) de manière à exclure une conduction simultanée des transistors de puissance (M1, M2).

Application à la commande de moteurs de petite puissance.

FIG. 1

EP 0 700 151 A1

## Description

La présente invention concerne un étage amplificateur de puissance, du type suiveur de tension recevant un signal d'entrée en tension et délivrant un signal de sortie, étage comportant en sortie un premier transistor MOS de puissance dont la source est couplée à une ligne de mode commun, en série avec un deuxième transistor MOS de puissance dont le drain est couplé à une ligne d'alimentation positive, ces deux transistors étant du même type de conductivité et leur point de connexion mutuelle délivrant ledit signal de sortie de l'étage, étage qui comporte également un premier amplificateur délivrant un premier signal de commande appliqué à la grille du premier transistor MOS de puissance, et un deuxième amplificateur délivrant un deuxième signal de commande appliqué à la grille du deuxième transistor MOS de puissance, le premier et le deuxième amplificateur recevant chacun sur une première entrée le signal d'entrée, auquel est comparé le signal de sortie de l'étage, appliqué sur une deuxième entrée.

Un étage amplificateur de puissance, à gain en tension égal à 1 est connu du document EP-A-0 492 374 en vue d'une application à la reproduction de signaux sonores.

Pour une application plus spécifiquement tournée vers la commande de moteurs, des transistors MOS de puissance sont également bien adaptés pour réaliser la sortie de l'étage d'amplification en puissance, du fait de leur robustesse en présence d'une charge inductive. Toutefois, ce type de transistor présente une capacité de grille élevée, couramment de l'ordre de grandeur d'une centaine de pF, de sorte que la commande de ces transistors nécessite d'utiliser un amplificateur capable de charger et décharger cette capacité de grille dans un délai compatible avec les spécifications recherchées.

Pour la même application, il est également souhaitable que l'état passant des transistors MOS de sortie puisse être commandé de manière très prononcée c'est-à-dire que la résistance au passage du courant soit la plus faible possible, par exemple Ron inférieur à 1 ohm.

Dans ces circonstances une gestion rigoureuse au cours du temps de l'état conducteur ou bloqué des deux transistors de puissance doit être assurée de manière à éviter un risque de destruction de ces transistors qui surviendrait si les deux transistors de puissance étaient simultanément conducteurs, même un court instant seulement.

Enfin un étage amplificateur de puissance, de type suiveur de tension devrait encore satisfaire à un critère de consommation en courant qui soit la plus faible possible lorsque l'étage est au repos, c'est-à-dire lorsque la tension d'entrée est égale à la tension de sortie de l'étage. Au contraire, pour des états transitoires durant lesquels l'amplificateur est hors équilibre, des courants importants doivent pouvoir être commandés en sortie, en réponse à des tensions d'erreur entrée/sortie aussi faibles que 100 ou 200 mV, et avec un délai de réponse qui soit conforme aux exigences de l'application.

L'étage amplificateur connu ne satisfait que partiellement à ces exigences du fait qu'il a plus spécialement été conçu en vue d'éviter la distorsion de croisement et non pas pour minimiser la consommation de courant au repos. En effet, dans l'étage amplificateur connu, l'aptitude à réagir rapidement en sortie, en réponse à une variation de la tension d'entrée est directement liée à la valeur du courant de repos. Ce courant de repos ne peut donc être choisi aussi faible qu'on le désire.

Aussi, l'un des buts de l'invention est-il de proposer un étage amplificateur de puissance perfectionné, remédiant dans une large mesure aux inconvénients du circuit connu, en vue de son application à l'alimentation d'un moteur.

En effet, selon la présente invention, un étage amplificateur du type indiqué dans le paragraphe introductif est caractérisé en ce qu'en vue d'exclure une conduction simultanée des deux transistors MOS de puissance, chacun des amplificateurs est muni d'une entrée dite de blocage et est agencé pour délivrer un signal de commande de grille égal à la tension de mode commun lorsque ladite entrée de blocage est portée à cette même tension de mode commun, et en ce que l'étage comporte deux transistors interrupteurs de type à effet de champ MOS chacun ayant sa source couplée à la ligne de mode commun, un premier transistor interrupteur ayant sa grille couplée à la grille du premier transistor MOS de puissance et son drain connecté à l'entrée de blocage du deuxième amplificateur, et un deuxième transistor interrupteur ayant sa grille qui reçoit un signal déduit de la tension de grille du deuxième transistor MOS de puissance et son drain qui est connecté à l'entrée de blocage du premier amplificateur.

Ainsi, lorsque l'un ou l'autre des deux transistors MOS de puissance est dans un état de forte conduction, l'autre transistor se trouve bloqué par l'effet de l'un des transistors interrupteurs. La possibilité d'une destruction des transistors de puissance par conduction simultanée, même pendant une brève durée transitoire, est ainsi évitée. L'étage amplificateur selon l'invention peut assurer à sa sortie un suivi très précis de la tension du signal d'entrée, lorsque cette tension ne varie pas ou varie lentement.

Lorsqu'au contraire, le signal d'entrée varie rapidement en imposant une commutation de l'état des transistors MOS de puissance, cette commutation, contrôlée par les transistors interrupteurs, est réalisée en assurant un délai de mise en conduction de l'un des transistors MOS de puissance égal au temps de mise hors conduction de l'autre transistor.

Ce délai peut être fixé en pratique à une valeur suffisamment faible pour ne pas être gênante dans le cas de l'alimentation d'un moteur, par exemple un délai de l'ordre de 1μs.

De préférence, le premier et le deuxième amplificateur délivrent les signaux de commande de grille, chacun, au moyen d'une paire de transistors bipolaires complémentaires dont les collecteurs sont couplés entre eux.

Cette configuration de transistors convient très bien en effet pour assurer efficacement la charge et la décharge de la grille des transistors MOS de puissance.

On observe aisément que le premier transistor MOS de puissance, référencé à la ligne de mode commun, a sa grille qui présente une excursion modérée en tension, depuis une tension nulle (masse) jusqu'à une tension grille-source assurant la conduction du transistor. En ce qui concerne le deuxième transistor MOS de puissance au contraire, sa grille peut être portée à une tension variant dans de larges proportions du fait du montage de ce transistor en suiveur. Comme la source du deuxième transistor interrupteur est connectée à la ligne de mode commun, sa grille peut être directement reliée à la grille du deuxième transistor MOS de puissance ce qui impose des exigences particulières de tenue en tension pour ledit deuxième transistor interrupteur.

Cependant, un mode avantageux de mise en oeuvre de l'invention est caractérisé en ce que dans la paire de transistors bipolaires complémentaires de sortie du deuxième amplificateur, celui des transistor dont l'émetteur est alimenté à tension positive, a son collecteur couplé au collecteur de l'autre transistor de la paire via un étage cascode, et en ce que le point de connexion entre le collecteur de cet autre transistor et l'étage cascode constitue l'entrée de blocage du deuxième amplificateur.

Cet étage cascode est de préférence réalisé avec un transistor MOS. Cette entrée de blocage du deuxième amplificateur, permet bien de commander à la masse la grille du deuxième transistor MOS de puissance pratiquement de la même manière que si l'entrée de blocage était connectée à la grille elle-même de ce transistor. L'avantage de l'étage cascode interposé est que l'entrée de blocage a une excursion de tension moins élevée que celle de la grille du deuxième transistor MOS de puissance, ce qui fait que selon un mode avantageux de réalisation, cette entrée de blocage constitue également une sortie pour le signal à appliquer à la grille du deuxième transistor interrupteur. La grille de ce deuxième transistor interrupteur reçoit donc un signal qui est déduit de la tension de grille du deuxième transistor MOS de puissance par écrêtage, ce qui permet d'utiliser un deuxième transistor interrupteur d'un type standard, sur la grille duquel l'excursion de tension reste limitée.

Pour assurer une commutation des amplificateurs par une commande en tension plutôt qu'en courant, l'entrée de blocage du premier amplificateur est prévue proche de l'entrée de cet amplificateur, où le courant à dériver est faible. Ainsi, selon un mode de réalisation préféré, l'étage amplificateur de puissance dans lequel le premier amplificateur comporte en entrée une paire différentielle de transistors bipolaires dont le point de connexion des émetteurs réunis est alimenté par un courant constant à partir de la ligne d'alimentation positive et dont les bases sont couplées aux entrées respectives de ce premier amplificateur, se caractérise selon l'invention en ce que le collecteur de l'un des transistors de ladite paire différentielle d'entrée constitue une entrée de blocage de ce premier amplificateur. Le collecteur en question est couplé à la ligne de mode commun (masse) à travers une charge qui peut être une diode d'entrée d'un miroir de courant. Le collecteur en question, d'une part, débite un courant faible, au maximum égal à celui du courant constant alimentant cette paire différentielle, et d'autre part présente une excursion de tension faible de sorte que cette électrode constite une entrée de blocage particulièrement avantageuse pour le premier amplificateur.

De préférence, l'étage amplificateur de puissance selon l'invention comporte en outre un générateur de type doubleur de tension, pour fournir une tension d'alimentation positive additionnelle plus élevée que la tension d'alimentation mentionnée en premier lieu, cette tension additionnelle étant utilisée pour l'alimentation du deuxième amplificateur.

L'étage amplificateur de puissance est alors susceptible de fournir une tension de sortie dont l'excursion peut s'étendre pratiquement depuis la tension de mode commun jusqu'à la tension d'alimentation positive normale. Le surplus de tension procuré par l'alimentation positive additionnelle permet alors la polarisation convenable de la grille du deuxième transistor MOS de puissance.

Il y a intérêt dans ce cas à limiter la consommation du courant délivré par l'alimentation positive additionnelle. L'étage amplificateur de puissance selon l'invention comporte avantageusement dans son deuxième amplificateur des moyens de limitation du courant consommé sur l'alimentation positive additionnelle, moyens qui sont agencés pour limiter ledit courant consommé à un multiple de la valeur du courant débité par une source de courant de référence, lequel multiple est établi par le rapport des surfaces d'émetteurs d'un miroir de courant, les moyens de limitation de courant étant complétés par ailleurs par deux autres miroirs de courant.

L'étage amplificateur selon l'invention est utilisé de préférence en association avec un autre étage identique, l'ensemble étant connecté pour former une alimentation de moteur de type en pont.

La description qui va suivre en regard des dessins annexés, donnés à titre d'exemples non limitatif fera bien comprendre en quoi consiste l'invention et comment elle peut être réalisée.

La figure 1 représente le schéma général d'un étage amplificateur selon l'invention,
la figure 2 représente le circuit électrique d'une partie de l'étage de la figure 1 selon un exemple de réalisation de l'invention, et
la figure 3 des courbes de courants relatives à la partie de circuit de la figure 2,
la figure 4 donne le schéma électrique d'une autre partie de l'étage de la figure 1, dans un premier mode de mise en oeuvre, et
la figure 5 le schéma électrique de la même partie, mais dans un autre mode de réalisation qui inclut des moyens de limitation du courant consommé sur la ligne d'alimentation positive, et

les figure 6 et 7 représentent des courbes de courants, en relation avec le circuit de la figure 5.

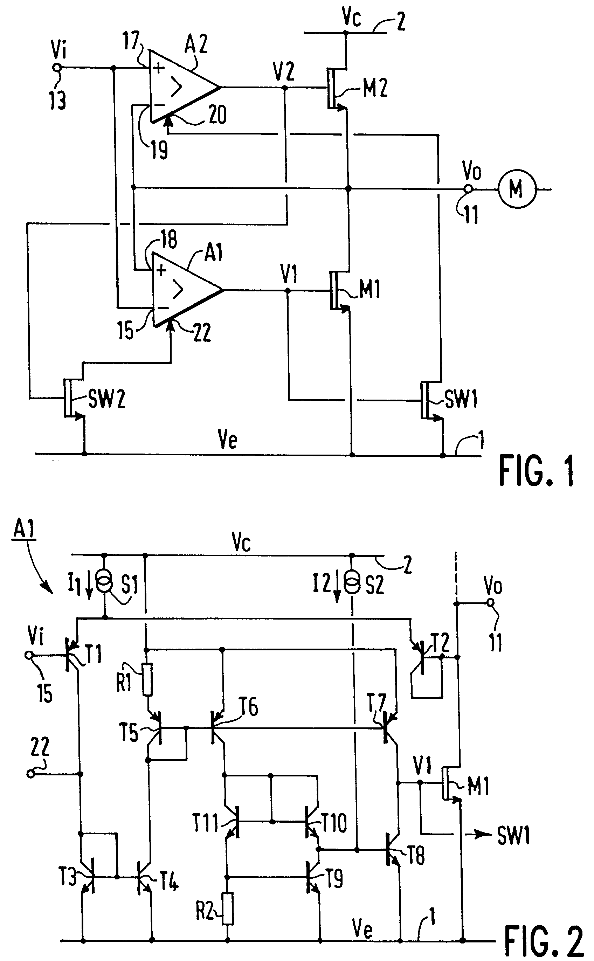

A la figure 1 est représenté un étage amplificateur de puissance de manière très schématique, étage qui est du type suiveur de tension, recevant un signal d'entrée Vi et délivrant un signal de sortie Vo notamment pour l'alimentation d'un moteur M. Cet étage comporte un premier amplificateur A1 délivrant un premier signal de commande V1 appliqué à la grille d'un premier transistor MOS de puissance M1. L'étage amplificateur comporte également un deuxième amplificateur A2 qui délivre un signal de commande V2 à la grille d'un deuxième transistor MOS de puissance M2. Les transistors M1 et M2 sont disposés en série entre une ligne de mode commun 1 (masse) présentant une tension Ve et une ligne d'alimentation positive 2 présentant une tension Vc. Les deux transistors M1 et M2 sont par ailleurs de même type, à canal N, la source du transistor M1 étant couplée à la ligne de mode commun 1, son drain couplé à la source du transistor M2, cette liaison formant la sortie de l'étage amplificateur présentant le signal de sortie Vo sur la borne 11', et le drain du transistor M2 étant couplé à la ligne d'alimentation positive 2. Le signal d'entrée Vi est appliqué à une borne d'entrée 13, couplée à une première entrée 15 du premier amplificateur A1 ainsi qu'à une première entrée 17 du deuxième amplificateur A2. Ces deux amplificateurs reçoivent sur une deuxième entrée, respectivement sur l'entrée 18 du premier amplificateur ainsi que sur l'entrée 19 du deuxième amplificateur, le signal de sortie Vo auquel le signal d'entrée Vi est comparé.

Selon l'invention, une conduction simultanée des deux transistors MOS de puissance M1 et M2 est évitée aux moyens de deux transistors dits interrupteurs, respectivement SW1 et SW2, lesquels transistors sont de type à effet de champ MOS et dont la source de chacun d'eux est connectée à la ligne de mode commun 1.

Le premier transistor interrupteur SW1 a sa grille connectée à la grille du transistor M1 et a son drain connecté à une entrée 20, dite de blocage, du deuxième amplificateur A2. L'amplificateur A2 est agencé de telle manière que lorsque son entrée de blocage 20 est portée à la tension Ve (masse), cet amplificateur A2 délivre un signal de commande de grille V2 qui est lui-même égal à la tension Ve ou très proche de cette tension, c'est-à-dire qu'il force le transistor M2 dans un état de blocage.

Une disposition similaire est appliquée à l'aide du deuxième transistor interrupteur SW2, lequel a sa grille couplée à la grille du transistor M2, ou comme on le verra par la suite, à une tension qui est dérivée de cette tension de grille, et a son drain couplé à une entrée de blocage 22 de l'amplificateur A1.

De même, lorsque l'entrée de blocage 22 est portée à la tension Ve (masse), l'amplificateur A1 délivre un signal de commande V1 lui-même sensiblement égal à la tension Ve de sorte que le transistor M1 est forcé dans un état de blocage.

Par cette disposition, l'un seulement des deux transistors MOS de puissance M1 ou M2 est susceptible d'être conducteur à un instant donné, sa tension de commande de grille étant différente de 0 et provoquant le blocage de la tension de commande en sortie de l'autre amplificateur. Tout risque de court-circuit entre la ligne d'alimentation positive 2 et la ligne de mode commun 1 est ainsi évité, court-circuit qui entraînerait un dommage irréparable de l'étage amplificateur de puissance, notamment la destruction de l'un ou l'autre des transistors de sortie de cet étage.

La figure 2 représente le schéma d'un exemple de réalisation de l'un des amplificateurs, tel que l'amplificateur A1 de la figure 1. Sur cette figure a également été représenté le premier transistor MOS de puissance M1 ainsi que la borne de sortie 11 de l'étage amplificateur portant la tension de sortie Vo.

L'entrée 15 de l'amplificateur porte la tension Vi. Cette tension d'entrée est comparée à la tension de sortie Vo au moyen d'une paire différentielle de transistors T1, T2, de type PNP dont les émetteurs réunis sont alimentés par une source de courant S1 débitant un courant I1 à partir de la tension d'alimentation positive Vc. Le transistor T2 est connecté en diode alors que le transistor T1 a son collecteur couplé à la ligne de mode commun 1 à travers la branche d'entrée d'un miroir de courant T3, T4 à transistors NPN. Le transistor d'entrée T3 de ce miroir de courant est connecté en diode tandis que le transistor de sortie T4 débite un courant identique à celui fourni par le transistor T1, courant qui provient d'un transistor PNP T5, connecté en diode. Le transistor T5 a sa base couplée à la base de deux autres transistors PNP, T6 et T7. Le transistor T5 a son émetteur couplé à la ligne d'alimentation positive 2 à travers une résistance d'émetteur R1, les transistors T6 et T7, par contre, ont leur émetteur directement connectè à la ligne d'alimentation 2.

L'ensemble des transistors T5, T6 et T7 forme un amplificateur de courant, les courants délivrés par les transistors T6 et T7 étant égaux puisque ces deux transistors sont montés en miroir de courant. Le collecteur du transistor T7 est connecté au collecteur d'un transistor NPN T8 dont l'émetteur est connecté à la ligne de mode commun 1. Cette paire de transistors T7, T8 constitue la sortie de l'amplificateur, délivrant une tension de commande V1 à la grille du transistor MOS de puissance M1. La base du transistor T8 est d'une part connectée à une source de courant S2 débitant un courant I2. Elle est d'autre part connectée au collecteur d'un transistor NPN T9 faisant partie d'un montage constitué de deux transistors NPN montés en diode T10, T11 couplés au collecteur du transistor PNP T6, montage qui comporte en outre, une résistance R2 reliant la base du transistor T9 à la ligne de mode commun 1, cette base étant également reliée à l'émetteur du transistor T11.

Ce montage et notamment la valeur de la résistance R2 sont prévus pour que les courants débités par les transistors T7 et T8 soient égaux lorsque la tension différentielle (Vi - Vo) est voisine de zéro ce qui représente l'état d'équilibre de l'amplificateur.

Lorsque momentanément, la tension du signal d'entrée Vi est supérieure à la tension de sortie Vo, le courant débité par le transistor T1 est inférieur à son courant nominal (à l'équilibre) et il en va de même pour le courant absorbé par le transistor T4 à la sortie du miroir de courant T3, T4. Dans ces conditions, le courant débité par les transistors T6 et T7 est inférieur à la valeur nominale de repos. Le transistor T9 est pratiquement bloqué ainsi que le transistor T10. Le courant I2 de la source de courant S2 alimente donc en totalité la base du transistor T8 lequel débite son courant maximum.

Lorsque la tension du signal d'entrée Vi est au contraire inférieure, provisoirement, à la tension de sortie Vo, le transistor d'entrée T1 de la paire T1, T2, débite un courant plus important que son courant nominal, lequel est amplifié par le montage formé de la résistance R1, des transistors T5, T6 et T7, les transistors T6 et T7 débitent alors tous les deux un courant nettement amplifié du fait de la chute de tension dans la résistance d'émetteur R1. Le courant important débité par le transistor T6 provoque à travers le transistor T11 monté en diode une chute de tension dans la résistance R2 assez élevée par rapport à la tension émetteur/base du transistor T9 de sorte que ce transistor débite et absorbe la majeure partie du courant I2 fourni par la source de courant S2. Ainsi, lorsque le transistor de sortie T7 débite, le transistor T8 ne débite pratiquement plus.

L'avantage d'un circuit tel que décrit à la figure 2, réalisé en majorité à l'aide de transistors bipolaires, est que l'amplificateur est à même de fournir en sortie un signal de commande V1 pour la grille du transistor MOS de puissance M1, sous la forme d'un courant de charge ou de décharge de la capacité de grille de ce transistor, pouvant être de valeur relativement élevée (quelques milliampères) dans le cas d'un déséquilibre transitoire de l'amplificateur. Lorsque cet amplificateur est revenu à l'équilibre, la tension de sortie Vo étant devenue très voisine de la tension d'entrée Vi, les courants égaux l'un débité et l'autre absorbé respectivement par le transistor T7 et le transistor T8, en sortie de l'amplificateur, sont très faibles et peuvent être réduits à une valeur inférieure à 50 µA par exemple.

En ce qui concerne cet amplificateur A1, on remarque que la tension de commande V1 appliquée à la grille du transistor M1 nécessite une excursion relativement faible, entre une tension nulle et une tension grille-source suffisante pour placer le transistor M1 en conduction prononcée. Dans ces circonstances, il est particulièrement simple d'utiliser la tension de commande V1 prélevée sur la grille du transistor M1 en tant que tension de grille pour le transistor interrupteur SW1 (non représenté à la figure 2) dont la conduction simultanée à la conduction du transistor M1 produira la mise en blocage du deuxième amplificateur A2 conformément à la figure 1.

Une entrée de blocage de l'amplificateur A1 doit être prévue de sorte que cette entrée étant mise à la masse, l'amplificateur A1 commande le transistor de puissance M1 au blocage. Avantageusement une telle entrée de blocage visible à la référence 22 sur la figure, est reliée à la connexion entre le collecteur du transistor T1 et le collecteur du transistor T3 du miroir T3, T4. Lorsque cette entrée 22 est mise à la masse, le courant débité par le transistor T1 est dérivé en dehors du miroir de courant T3, T4 de sorte que le transistor T4 ne débite plus, de même pour les transistors T5, T6 et T7. Comme on l'a vu précédemment, le transistor T9 ne débite pratiquement pas, de sorte que tout le courant I2 de la source de courant S2 est introduit en tant que courant de base du transistor T8. Ce transistor débite un courant de décharge de la grille du transistor de puissance M1, tant que cette grille est chargée, le transistor T8 entrant en saturation lorsque la grille du transistor M1 est complètement déchargée.

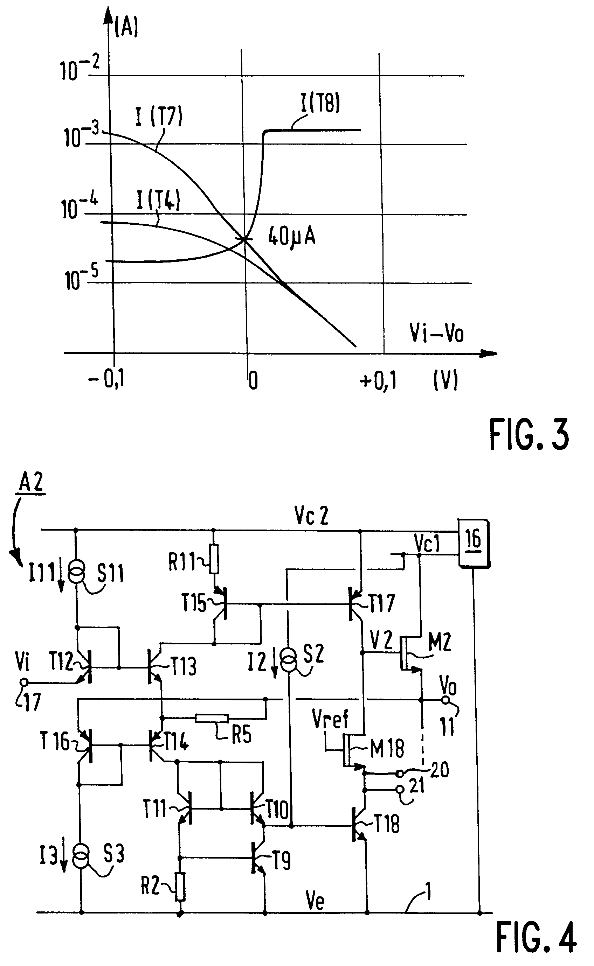

On a représenté à la figure 3, l'allure, en phase transitoire, des courants : I(T4), débité par le transistor T4, I(T7) débité par le transistor T7 et I(T8) débité par le transistor T8, en fonction du déséquilibre de tension, entre la tension d'entrée Vi et la tension de sortie Vo. L'échelle logarithmique des courants utilisée sur la figure montre que l'action sur la grille du transistor MOS de puissance M1 est très puissante en cas de déséquilibre de la tension d'entrée, tandis qu'au repos, l'amplificateur ne débite en sortie que 40µA environ par les transistors T7 et T8, dans un exemple pratique .

La figure 4 représente le schéma électrique d'un mode de réalisation de l'amplificateur A2 de la figure 1. Sur cette figure 4, le deuxième transistor MOS de puissance M2 a été également représenté auquel l'étage amplificateur représenté fournit le signal de commande de grille V2. L'amplificateur A2 commandant le transistor M2 est construit grossièrement sur le même principe que l'amplificateur A1 représenté à la figure 2.

Dans la mesure ou les mêmes éléments figurent dans la même fonction, ils sont affectés des signes de référence identiques à ceux des figures précédentes. A la figure 4, le transisor NPN T18 occupe sensiblement la même fonction que le transistor T8 de la figure 2 dont la base est alimentée par une source de courant S2 débitant un courant I2. Selon le mode de mise en oeuvre présenté, le collecteur du transistor T18 est couplé au collecteur d'un transistor PNP T17 via un étage cascode réalisé par un transistor MOS M18 dont la grille est polarisée à une tension de référence Vref. Ainsi la tension V2 de commande de grille du transistor M2 est prélevée dans la connexion reliant le collecteur du transistor T17 au drain du transistor M18. Comme la tension de sortie Vo de l'étage amplificateur est reliée à la source du transistor de puissance M2 cette tension de sortie Vo peut atteindre la tension d'alimentation positive $V_{c1}$ à condition que sa tension de commande de grille V2 puisse monter au-delà de cette tension positive $V_{c1}$. C'est pourquoi l'amplificateur A2 est représenté comme étant alimenté positivement par une tension $V_{c2}$, plus élevée que $V_{c1}$, qui est produite par un circuit doubleur de tension 16 d'un type classique, à partir de la tension $V_{c1}$.

Dans un exemple de réalisation, la tension $V_{c1}$ est égale à 12 Volts alors que la tension $V_{c2}$ est de l'ordre de 18 Volts. Le montage constitué des transistors T9, T10, T11 et de la résistance R2, destiné à la commande du courant de base du transistor T18 est le même que le montage décrit précédemment à la figure 2, à propos de la commande du courant de base du transistor T8. Le signal Vi présenté à la borne d'entrée 17 de l'amplificateur A2 est comparé au signal de sortie Vo au moyen de deux paires de transistors. Une première paire de transistors NPN T12, T13 est attaquée sur les émetteurs de ces transistors tandis que les bases réunies de ces transistors T12, T13 sont alimentées par une source de courant S11 débitant un courant I11. De plus le transistor T12 est connecté en diode par connexion entre base et collecteur.

Une deuxième paire de transistors T14, T16 de type PNP réalise un ensemble comparateur symétrique des deux transistors précédents dans lequel le transistor T16 est connecté en diode et alimenté par une source de courant S3 débitant un courant I3 vers la ligne de mode commun 1. En définitive le comparateur formé des transistors T12, T13, T14, T16 constitue un amplificateur de courant débité par les transistors T13, T14 lorsque la tension d'entrée Vi est plus élevée que le tension de sortie Vo les courants débités par les transistors T13 et T14 restant par ailleurs identiques entre eux.

Lorsque la tension d'entrée Vi est plus faible que la tension de sortie Vo les transistors T13 et T14 sont placés dans un état proche du blocage dans lequel ces transistors débitent un courant très inférieur au courant de repos de l'étage à l'équilibre, obtenu lorsque Vo est égal à Vi. Le transistor T14 joue le même rôle que le transistor T6 du schéma de la figure 2. Lorsque le courant de T14 augmente au dessus du courant nominal de repos, le transistor T18 est commandé vers le blocage par absorption du courant de la source de courant S2 par le transistor T9. Dans la même hypothèse le transistor T13 débite un courant qui est amplifié par le montage d'un transistor T15 monté en diode et présentant une résistance d'émetteur R11 couplé en parallèle avec le transistor T17, qui forme avec le transistor T18 la paire de transistors de sortie. Bien évidemment lorsque le courant débité par le transistor T13 augmente, le courant débité par le transistor T17 s'accroît encore plus vite. Les courants transitoires débités par les transistors T17 et T18 peuvent être relativement importants comme dans le montage précédent c'est-à-dire de l'ordre de quelques milliampères alors que le courant de repos de ces deux transistors est réglé par exemple à 40 μA lorsque l'amplificateur est à l'équilibre, (tension d'entrée égale à la tension de sortie).

Comme indiqué sur la figure 4, une résistance R5 a été disposée en parallèle entre les émetteurs des transistors T14 et T16. Cette résistance R5 est optionnelle, elle est de valeur élevée par exemple 50Kohms et à pour effet d'éviter que la connexion entre l'émetteur du transistor T13 et l' émetteur du transistor T14 ne soit flottante en cas de déséquilibre prononcé de l'amplificateur.

Les caractéristiques d'amplification de l'amplificateur A2 sont sensiblement identiques à celles de l'amplificateur A1 décrit à la figure 2.

La tension de commande V2 de la grille du transistor MOS de puissance M2 varie dans de larges proportions et ici depuis une tension nulle jusqu'à pratiquement la tension de $V_{c2}$, à la tension de saturation près du transistor T17. La connexion de grille du transistor de puissance M2 peut donc constituer à la fois une sortie pour commander le deuxième transistor interrupteur SW2 (non représenté figure 4) et également une borne d'entrée pour la commande de blocage de cet amplificateur A2 puisque le transistor M2 sera bloqué lorsque sa grille est mise à la masse. Toutefois, dans le montage représenté à la figure 4, la connexion entre la source du transistor M18 et le collecteur du transistor T18 constitue une sortie préférée, représentée par une borne 21, pour la commande du deuxième transistor interrupteur SW2. En effet, la tension obtenue sur la borne 21 se déduit de la tension de grille du transistor M2, à l'écrêtage près réalisé par le transistor cascode M18, qui fixe une tension maximale à la tension de sortie de la borne 21, égale à la tension de référence Vref moins la tension de seuil de ce transistor. Comme la tension sur la borne 21 présente une excursion plus faible que la tension de grille du transistor M2, cette borne 21 constitue donc une commande avantageuse du deuxième transistor interrupteur SW2 qui peut alors être d'un type ordinaire ne nécessitant pas une tenue en tension aussi élevée que la tension susceptible de se présenter sur la grille du transistor M2.

Le collecteur du transistor T18 peut constituer également la borne d'entrée 20 pour la commande de blocage de l'amplificateur A2. En effet, lorsque la borne 20 est couplée à la masse, le transistor cascode M18 est nécessairement conducteur de sorte que le courant délivré par le transistor T17 est dérivé vers la masse. Le transistor M2 se trouve alors bloqué.

Lorsque l'amplificateur A2 est alimenté à partir d'une tension d'alimentation positive $V_{c2}$ plus élevée que la tension d'alimentation normale du circuit $V_{c1}$, comme cela est représenté à la figure 4, il est avantageux de fixer une limite au courant débité par le transistor T17 ainsi qu'aux courants délivrés par les transistors T13 et T15.

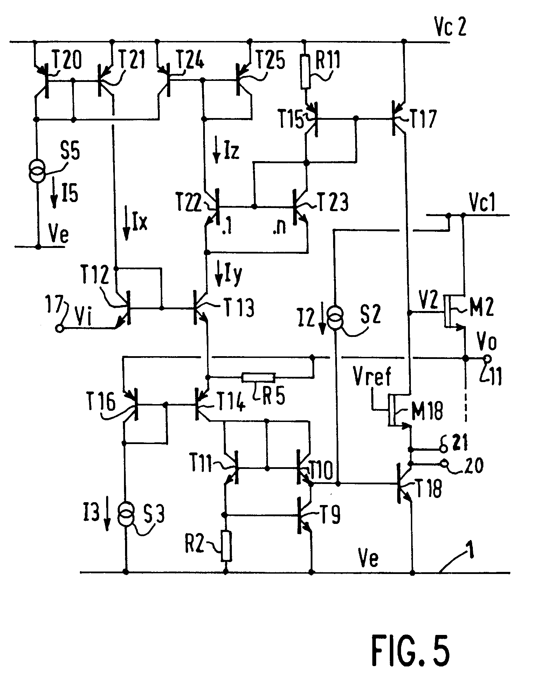

Dans ce but, à la figure 5, un deuxième mode de mise en oeuvre de l'amplificateur A2 est représenté qui comporte une modification permettant une telle limitation de courant. Selon ce mode de mise en oeuvre, la partie concernant la commande du transistor T18 reste identique à celle représentée à la figure 4 alors que la modification de circuit concerne la partie de commande du transistor T17. Les moyens permettant de limiter le courant dans les transistors T17 et T15 sont essentiellement constitués par une première paire de transistors PNP T20, T21, montés en miroir de courant, une deuxième paire de transistors PNP T24, T25 montés en miroir de courant et une troisième paire de transistors T22, T23 de type NPN laquelle est montée en miroir de courant, de rapport diviseur n à 1 entre son entrée et sa sortie.

Pour l'alimentation en courant de la paire de transistors T12, T13, une source de courant de référence S5, référencée à la tension de mode commun Ve, débite un courant de référence I5 dans le miroir de courant T20, T21. Le courant collecteur du transistor T13 est variable et dépend du déséquilibre entre la tension d'entrée Vi et la tension de sortie Vo. Ce courant est noté Iy sur la figure. Une fraction connue, notée Iz de ce courant Iy qui est déterminée par le rapport de surface des transistors T22, T23 est absorbée à l'entrée du miroir de courant T24, T25. Le même courant Iz est finalement fourni à la source de courant S5. Le courant, noté Ix, qui est délivré par le miroir de courant T20, T21 est finalement égal à la différence entre le courant I5 et le courant Iz. L'autre partie du courant Iy débitée par le transistor T13, partie qui est égale à n.Iz du fait du rapport des dimensions du miroir de courant T22, T23, est appliquée à l'entrée du montage amplificateur T15, T17 montage amplificateur déjà utilisé et décrit en rapport avec la figure 4.

Le courant n.Iz tel qu'il est absorbé à l'entrée du montage T15, T17 peut être facilement évalué :

$$Iz = Iy / (n+1) \text{ et } n.Iz = n.Iy / (n+1) \qquad (1)$$

du fait du partage du courant Iy dans le miroir de courant T22, T23.

Par ailleurs, Iz est soustrait à I5 à l'entrée du miroir de courant T20, T21 de sorte que :

$$Ix = I5 - Iz \qquad (2)$$

Lorsque l'amplificateur est totalement déséquilibré, tout le courant Ix est introduit dans la base du transistor T13 de sorte qu'alors :

$$Iy = \beta Ix \qquad (3)$$

avec β = gain en courant d'un transistor NPN
En combinant les équations (1) à (3), il vient qu'une valeur limite de Iz est :

$$Iz = \beta.Ix / (n+1) = (\beta I5 - \beta Iz) / (n+1)$$

$$Iz = I5.\frac{\beta}{\beta+n+1}$$

et le courant nIz absorbé par T23 dans T15 est au maximum de :

$$nIz = I5.\frac{n\beta}{\beta+n+1}$$

Lorsque le gain β est grand devant n, le courant n.Iz tend vèrs :

$$nIz \approx n.I5$$

A titre d'exemple pour un rapport n = 10, un gain β de 100 et un courant de référence I5 de 10µA, il vient

que le courant de limitation nIz absorbé par le transistor T23 est alors de l'ordre de 90 à 100µA.

Compte tenue de la valeur choisie pour la résistance d'émetteur R11 on peut connaître précisément le courant maximum susceptible d'être débité par le transistor T17 dans le cas d'un déséquilibre très prononcé de l'amplificateur A2.

Lorsque la grille du transistor M2 est totalement chargée par le transistor T17, celui-ci entre en saturation et son collecteur ne peut plus débiter. Le courant consommé si l'amplificateur était maintenu en déséquilibre se réduirait alors au courant débité par le transistor T23 c'est-à-dire un courant environ 20 fois plus faible que le courant maximal de charge du transistor T17 lorsqu'il n'est pas saturé (état transitoire).

On voit que le circuit limiteur de courant tel que décrit à la figure 5 est particulièrement efficace. Il permet de fixer une limite aux courants consommés sur l'alimentation positive additionnelle $V_{c2}$ limite qui est alors indépendante du gain des transistors et de la variation du gain avec la température, ce qui n'était pas le cas pour le circuit représenté à la figure 4.

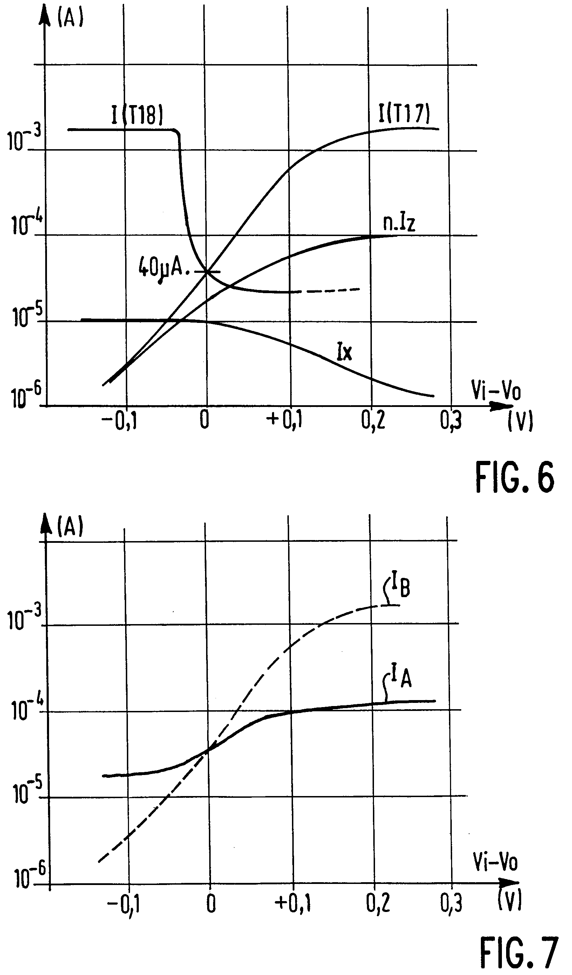

La figure 6 représente l'allure des courants Ix, débité par le transistor T12, n.Iz débité par le transistor T23, I(T17) débité par le transistor T17 et I(T18) débité par le transistor T18, en fonction d'un déséquilibre transitoire de tension (Vi - Vo). Une échelle de courant logarithmique a été utilisée. Les courbes de la figure 6 montrent le taux d'amplification élevé en courant, lorsque l'amplificateur est dans un état de déséquilibre transitoire.

La figure 7 représente à la courbe $I_A$ le courant total prélevé sur l'alimentation positive additionnelle $V_{c2}$ en fonction de la tension différentielle (Vi - Vo) en régime permanent et notamment lorsque le transistor T17 est saturé. Pour comparaison, la courbe $I_B$ représentée en tirets, est identique à la courbe I(T17) de la figure 6. Il est clairement apparent que le limiteur de courant décrit à la figure 5 est particulièrement efficace dans le cas d'un déséquilibre statique de l'amplificateur bien qu'il autorise cependant un courant de charge important en régime transitoire.

Des modifications de détail par raport aux exemples décrits précédemment peuvent être apportées à la réalisation de l'étage amplificateur de puissance sans pour autant sortir du cadre de l'invention revendiquée ci-après.

**Revendications**

1.  Etage amplificateur de puissance, du type suiveur de tension recevant un signal d'entrée en tension (Vi) et délivrant un signal de sortie (Vo), étage comportant en sortie un premier transistor MOS de puissance (M1) dont la source est couplée à une ligne de mode commun (1), en série avec un deuxième transistor MOS de puissance (M2) dont le drain est couplé à une ligne d'alimentation positive (2), ces deux transistors étant du même type de conductivité et leur point de connexion mutuelle délivrant ledit signal de sortie de l'étage, étage qui comporte également un premier amplificateur (A1) délivrant un premier signal de commande (V1) appliqué à la grille du premier transistor MOS de puissance, et un deuxième amplificateur (A2) délivrant un deuxième signal de commande (V2) appliqué à la grille du deuxième transistor MOS de puissance, le premier et le deuxième amplificateur recevant chacun sur une première entrée le signal d'entrée (Vi), auquel est comparé le signal de sortie (Vo) de l'étage, appliqué sur une deuxième entrée,

caractérisé en ce qu'en vue d'exclure une conduction simultanée des deux transistors MOS de puissance (M1, M2), chacun des amplificateurs (A1, A2) est muni d'une entrée dite de blocage (22, 20) et est agencé pour délivrer un signal de commande de grille égal à la tension de mode commun (Ve) lorsque ladite entrée de blocage est portée à cette même tension de mode commun, et en ce que l'étage comporte deux transistors interrupteurs de type à effet de champ MOS chacun ayant sa source couplée à la ligne de mode commun (1), un premier transistor interrupteur (SW1) ayant sa grille couplée à la grille du premier transistor MOS de puissance (M1) et son drain connecté à l'entrée de blocage (20) du deuxième amplificateur (A2), et un deuxième transistor interrupteur (SW2) ayant sa grille qui reçoit un signal déduit de la tension de grille du deuxième transistor MOS de puissance (M2) et son drain qui est connecté à l'entrée de blocage (22) du premier amplificateur (A1).

2.  Etage amplificateur de puissance selon la revendication 1, caractérisé en ce que le premier et le deuxième amplificateur délivrent lesdits signaux de commande de grille chacun au moyen d'une paire de transistors bipolaires complémentaires (T7-T8, T17-T18) dont les collecteurs sont couplés entre eux.

3.  Etage amplificateur de puissance selon la revendication 2, caractérisé en ce que dans la paire de transistors bipolaires complémentaires de sortie du deuxième amplificateur (A2), celui (T17) des transistors dont l'émetteur est alimenté à tension positive a son collecteur couplé au collecteur de l'autre transistor (T18) de la paire via un étage cascode (M18) et en ce que le point de connexion entre le collecteur de cet autre transistor et l'étage cascode constitue l'entrée de blocage (20) du deuxième amplificateur (A2).

4.  Etage amplificateur de puissance selon la revendication 3, caractérisé en ce que l'entrée de blocage (20) du deuxième amplificateur (A2) constitue également une sortie (21) pour le signal appliqué à la grille du deuxième transistor interrupteur (SW2).

5.  Etage amplificateur de puissance selon l'une des revendications 1 ou 2, caractérisé en ce que la connexion de grille du deuxième transistor MOS de puissance (M2) constitue l'entrée de blocage du deuxième amplificateur (A2).

6.  Etage amplificateur de puissance selon l'une des revendications 1 à 5, dans lequel le premier amplificateur (A1) comporte en entrée une paire différentielle de transistors bipolaires (T1, T2) dont le point de connexion des émetteurs réunis est alimenté par un courant constant (I1) à partir de la ligne d'alimentation positive et dont les bases sont couplées aux entrées respectives de ce premier amplificateur, caractérisé en ce que le collecteur de l'un des transistors (T1) de ladite paire différentielle d'entrée constitue l'entrée de blocage (22) de ce premier amplificateur.

7.  Etage amplificateur de puissance selon l'une des revendications 2 à 6, caractérisé en ce qu'il comporte un générateur (16) de type doubleur de tension, pour fournir une tension d'alimentation positive additionnelle ($V_{c2}$) plus élevée que la tension d'alimentation ($V_{c1}$) mentionnée en premier lieu, laquelle est utilisée pour l'alimentation du deuxième amplificateur (A2).

8.  Etage amplificateur de puissance selon la revendication 7 caractérisé en ce que le deuxième amplificateur (A2) comporte des moyens de limitation du courant consommé sur l'alimentation positive additionnelle ($V_{c2}$), moyens limitant ledit courant consommé à un multiple de la valeur du courant (I5) débité par une source de courant de référence (S5) lequel multiple est établi par le rapport des surfaces d'émetteurs d'un miroir de courant (T22-T23), lesdits moyens de limitation de courant étant complétés par deux autres miroirs de courant (T20-T21, T24-T25).

**FIG. 1**

**FIG. 2**

FIG. 3

FIG. 4

FIG. 5

FIG. 6

FIG. 7

Office européen
des brevets

**RAPPORT DE RECHERCHE EUROPEENNE**

Numero de la demande
EP 95 20 2183

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | DE-A-40 02 871 (CRYSTAL SEMICONDUCTOR CORP) * colonne 7, ligne 28 - colonne 14, ligne 44; figures 2,3,7 * | 1 | H03F3/30 H03F1/32 |
| A | US-A-5 121 011 (E. OHYA ET AL) * colonne 5, ligne 20 - colonne 11, ligne 35; figures 3-10 * | 1-5 | |
| A | US-A-4 480 230 (K.E. BREHMER ET AL) * colonne 3, ligne 14 - colonne 6, ligne 29; figures 4,5 * | 1,6 | |
| A | FUNKSCHAU, vol. 62, no. 10, 4 Mai 1990 MUNCHEN  DE, pages 105-107, XP 000116133 R.J. HORKY  'VOLLSYMMETRISCHER MOSFET-AMP MIT 200 W  TEIL 2' * page 105; figure 2 * | 1-3,6 | |
| A | IEEE JOURNAL OF SOLID-STATE CIRCUITS, vol. 26, no. 11, NEW YORK  US, pages 1681-1688, XP 000266681 Z.Y. CHANG ET AL  'DESIGN CONSIDERATIONS OF HIGH-DYNAMIC-RANGE WIDE-BAND AMPLIFIERS IN BICMOS TECHNOLOGY' * page 1684; figure 5 * | 3 | DOMAINES TECHNIQUES RECHERCHES (Int.Cl.6) H03F |
| A | DE-A-41 31 782 (SIEMENS AG) * colonne 4, ligne 24 - colonne 6, ligne 28; figure 2 * | 1,2,6-8 | |

Le présent rapport a été établi pour toutes les revendications

| Lieu de la recherche | Date d'achèvement de la recherche | Examinateur |
|---|---|---|
| LA HAYE | 30 Novembre 1995 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)